# EUROPÄISCHE PATENTSCHRIFT

(11) **EP 1 865 204 B1**
(45) Veröffentlichungstag und Bekanntmachung des Hinweises auf die Patenterteilung: **24.02.2010**
(21) Anmeldenummer: 07009904.9
(22) Anmeldetag: 18.05.2007
(51) Int. Cl.: F04D 27/00, F04D 29/36

(54) **Vorrichtung zur Messung des Verstellhubes einer hydraulischen Verstelleinrichtung**
Device for measuring the displacement stroke of a hydraulic displacement device
Dispositif destiné à la mesure de l'élévation du réglage d'un dispositif de réglage hydraulique

(30) Priorität: 07.06.2006 DE 102006026834
(43) Veröffentlichungstag der Anmeldung: 12.12.2007
(73) Patentinhaber: TLT-Turbo GmbH, 66482 Zweibrücken (DE)
(72) Erfinder: Schmidt, Jörg, 66482 Zweibrücken (DE)

(56) Entgegenhaltungen:
- CH-A- 449 837
- DE-A1- 2 546 161
- DE-U1- 20 218 754
- JP-A- 59 115 499
- US-A- 6 087 828
- US-A1- 2002 192 078

## Beschreibung

Die Erfindung betrifft eine Vorrichtung zur Messung des Verstellhubes einer hydraulischen Verstelleinrichtung für die Flügel des Laufrades eines Axialventilators mit den Merkmalen des Oberbegriffes des Anspruches 1.

Moderne Axialventilatoren (DE 25 46 161 A1, US 2002/0179078 A1, CH 449 837, JP 59115499 A) sind regelbare Arbeitsmaschinen, die mechanische Energie in Strömungsenergie umwandeln. Die Regelung der Axialventilatoren erfolgt über die Drehzahl oder die Anstellwinkel der Flügel. Soll die Flügelstellung während des Betriebs verändert werden können, muss der Flügel auf einer gelagerten Welle, dem Holm befestigt sein. Die Veränderung der Flügelstellung geschieht meist hydraulisch. Zu dem Zweck wird eine hydraulische Verstellvorrichtung an das Laufrad des Axialventilators angebaut. Eine solche Verstellvorrichtung besteht im Wesentlichen aus einer hydraulischen Verstellzylinder-Anordnung, die mit der Ventilatordrehzahl rotiert und aus einem nicht rotierenden Ölübergangsstück, an das die Ölversorgungsleitungen angeschlossen sind.

Die Stellung der Flügel des Axialventilators entspricht einer bestimmten Stellung der Verstellzylinder-Anordnung. Diese Stellung wird über eine Stellungsanzeige (DE 25 46 161 A1), die mechanisch mit dem verschiebbaren Teil der Verstellzylinder-Anordnung verbunden ist, außerhalb des Ventilatorgehäuses angezeigt und kann auch mittels eines angekoppelten Winkelcodierers zu einer Warte weitergeleitet werden. Eine derartige mechanische Anordnung zur Stellungsanzeige ist verhältnismäßig ungenau. Wegen der mechanischen Verbindung ist außerdem ein Verschleiß in den Verbindungsteilen zu berücksichtigen.

Aus der JP 59115499 A, die als nächstliegender Stand der Technik angesehen wird, ist ein Axialventilator mit einer Anzeigeeinrichtung bekannt, bei der die Bewegung eines Verstellzylinders auf einen damit verbundenen Eisenkern Übertragen wird, der in die Spule der Anzeigeeinrichtung eintaucht.

Aus der US 3 898 555 A oder der US 6 087 828 A ist eine magnetostriktive Wegmesseinrichtung bekannt, die aus einem Wellenleiter innerhalb eines zylindrischen Gehäuses besteht, das von einem ringförmigen Magneten umschlossen ist. Das Gehäuse der magnetostriktiven Wegmesseinrichtung ist auf dem feststehenden Teil und der Magnet ist auf dem beweglichen Teil eines Fahrzeuges angeordnet (US 6 087 828 A).

Die vorliegende Erfindung befasst sich mit dem Problem, eine vorteilhafte Einrichtung zum Messen des Verstellhubes der hydraulischen Verstelleinrichtung von Axialventilatoren vorzusehen.

Der Erfindung liegt die Aufgabe zugrunde, für die gattungsgemäße Vorrichtung eine Wegmesseinrichtung vorzusehen, die mit relativ hoher Genauigkeit arbeitet, Absolutwerte liefert und frei von Verschleiß ist. Eine solche Einrichtung muss für den Messeinsatz an der Flügelverstelleinrichtung im Nabenraum des Axialventilators geeignet sein.

Die Aufgabe wird bei einer gattungsgemäßen Vorrichtung erfingdungsgemäß durch die kennzeichnenden Merkmale des Anspruches 1 gelöst. Vorteilhafte Ausgestaltungen der Erfindung sind in den Unteransprüchen angegeben.

Die Lösung der Aufgabe liegt in der Anwendung der an sich, z. B. aus der US 3 898 555 A, bekannten magnetostriktiven Wegmesseinrichtung für den angegebenen Zweck. Die Einrichtungen zeichnen sich durch eine relativ hohe Genauigkeit, eine geringe Linearitätstoleranz und eine sehr hohe Messwiederholungsgenauigkeit aus. Die Wegmesseinrichtungen liefern eine Absolutwertmessung, so dass eine Referenzmarken-Anfahrt entbehrlich ist. Schließlich arbeitet das Messsystem berührungslos, so dass ein Verschleiß zwischen den relativ zueinander dreh- und verschiebbaren Teilen des Messsystems und der Verstelleinrichtung nicht auftritt. Die magnetostriktiven Wegmesseinrichtungen werden gemäß der Erfindung an der Flügelverstelleinrichtung im Nabenraum des Axialventilators eingebaut und sind in vorteilhafter Weise an die dort vorhandenen besonderen konstruktiven Gegebenheiten angepasst.

Mehrere Ausführungsbeispiele der Erfindung sind in der Zeichnung dargestellt und werden im Folgenden näher erläutert. Es zeigen:
- Fig. 1: einen Längsschnitt durch ein Laufrad eines Axialventilators mit einer Verstelleinrichtung nach der Erfindung und
- Fig. 2: einen Längsschnitt durch ein Laufrad eines Axialventilators mit einer Verstelleinrichtung gemäß einer anderen Ausführungsform.

Ein Laufrad 1 eines Axialventilators ist auf seinem Umfang mit mehreren Flügeln 2 bestückt, von denen ein Flügel teilweise gezeigt ist. Die Flügel 2 sind zur Anpassung des Axialventilators an die verschiedenen Betriebspunkte um ihre Längsachse anstellbar. Dazu ist ein die Flügel 2 tragender Holm 3 in einem Tragring 4 des Laufrades 1 drehbar gelagert. An jedem Holm 3 ist ein abgekröpfter Verstellhebel 5 befestigt, der in einer am Umfang einer Verstellscheibe 22 angebrachten Nut geführt ist.

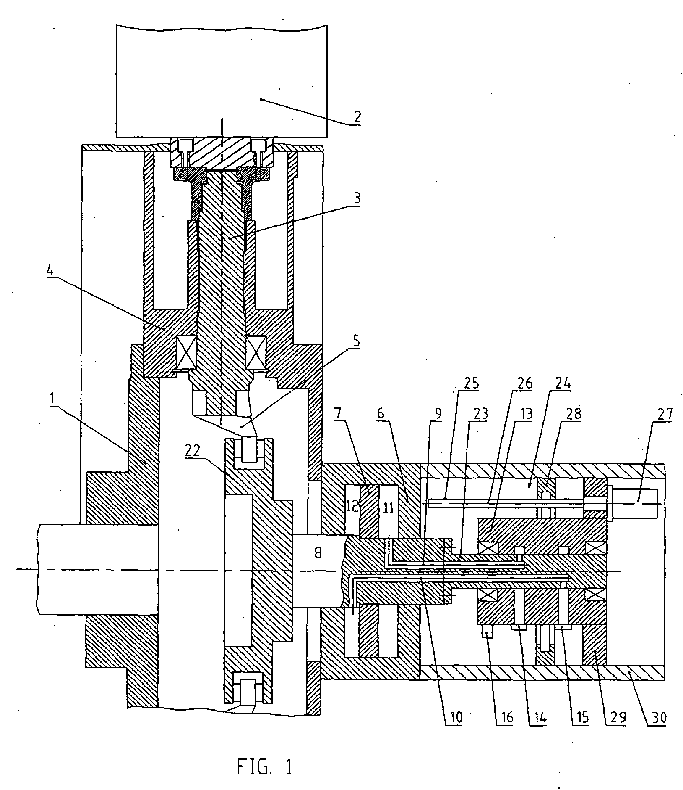

Gemäß Fig. 1 ist die Verstellscheibe 22 mit einer Kolbenstange 8 verbunden, auf der ein Kolben 7 befestigt ist. Der Kolben 7 befindet sich innerhalb eines Verstellzylinders 6. Die Kolbenstange 8 mit dem Kolben 7 und die Verstellscheibe 22 sind entlang der Achse des Axialventilators verschiebbar angeordnet und rotieren mit der gleichen Drehzahl wie das Laufrad 1 und der Verstellzylinder 6. Der Verstellzylinder 6 ist mit dem Laufrad 1 verbunden und steht relativ zur Kolbenstange 8 und zum Kolben 7 still.

Das dem Laufrad 1 abgewandte Ende der Kolbenstange 8 ist zur Verlängerung mit einer Welle 23 verschraubt, die innerhalb eines nicht rotierenden Ölübergangsstücks 13 umläuft. Durch die Kolbenstange 8 und die Welle 23 sind axiale Steuerkanäle 9, 10 geführt, die beiderseits des Kolbens 7 jeweils in einen der Kolbenräume 11, 12 münden. Das Ölübergangsstück 13 dient der Versorgung des Verstellzylinders 6 mit Drucköl und ist mit einem Leckölablauf 16 und mit zwei Versorgungsleitungen 14, 15 für die beiden Kolbenräume 11, 12 versehen. Die Versorgungsleitungen 14, 15 dienen dem jeweiligen Kolbenraum sowohl als Vorlauf als auch als Rücklauf, je nach dem, in welche Richtung der Kolben 7 auf der Kolbenstange 8 mit der Verstellscheibe 22 verstellt werden soll.

Zur Messung des Verstellhubes, den der Kolben 7 auf der Kolbenstange 8 zur Anstellung der Flügel 2 ausführt, ist eine magnetostriktive Wegmesseinrichtung 24 vorgesehen, wie diese beispielsweise aus der US 3 398 555 A bekannt ist.

Die magnetostriktive Wegmesseinrichtung 24 besteht im vorliegenden Ausführungsbeispiel aus verschiedenen Komponenten, und zwar aus einem stabförmigen Sensorgehäuse 25, das einen Wellenleiter 26 aus ferromagnetischem Material umgibt, aus einem mit dem Sensorgehäuse 25 verbundenen Sensorkopf 27, der die Elektronik zur Signalaufbereitung trägt, und aus einem permanenten, relativ zum Sensorgehäuse 25 beweglichen Magneten 28 als Positionsgeber. Das Sensorgehäuse 25 kann auch als Profil-Ausführung oder dergleichen ausgebildet sein.

Gemäß Fig. 1 ist der Sensorkopf 27 zusammen mit dem stabförmigen Sensorgehäuse 25 der magnetostriktiven Wegmesseinrichtung 24 fest in einem Ringflansch 29 eingesetzt, der an dem Ölübergangsstück 13 befestigt ist. Dabei ist das Sensorgehäuse 25 in Richtung der Achse des Axialventilators und damit in Bewegungsrichtung der Kolbenstange 8 ausgerichtet. Anstelle einer Wegmesseinrichtung 24 - wie dargestellt - können auch mehrere Wegmesseinrichtungen in den Ringflansch 29 des Ölübergangsstückes 13 eingesetzt werden.

Der Magnet 28 der magnetostriktiven Wegmesseinrichtung 24 ist als Ringmagnet mit einem internen Magnetband ausgebildet. Der Magnet 28 umgibt somit in einem vorbestimmten Bereich die Sensorgehäuse 25 aller montierten oder eingesetzten magnetostriktiven Wegmesseinrichtungen 24.

Die Wegmesseinrichtung 24 und das Ölübergangsstück 13 sind von einem Schutzrohr 30 umgeben, das mit dem Verstellzylinder 6 fest verbunden ist. An der Wandung des Schutzrohres 30 ist der ringförmige Magnet 28 befestigt. Das Schutzrohr 30 dient damit als Träger für den Magneten 28. Das Schutzrohr 30 mit dem Magneten 28 rotiert mit der Drehzahl des Axialventilators. Der Ringflansch 29 sowie die am Ringflansch befestigten Sensorgehäuse 25 rotieren nicht.

Um die Flügel 2 des Axialventilators zu verstellen, wird die Kolbenstange 8 und damit auch das Ölübergangsstück 13 axial bewegt. Hierbei bleibt axial betrachtet der Magnet 28, der an dem mit dem Verstellzylinder 6 verbundenen Schutzrohr 30 befestigt ist, in seiner Position. Die aus Sensorgehäuse 25 und Sensorkopf 27 bestehende Wegmesseinrichtung 24 mit dem Ringflansch 29 auf dem Ölübergangsstück 13 bewegt sich und gibt somit den Verstellhub als Wegsignal aus.

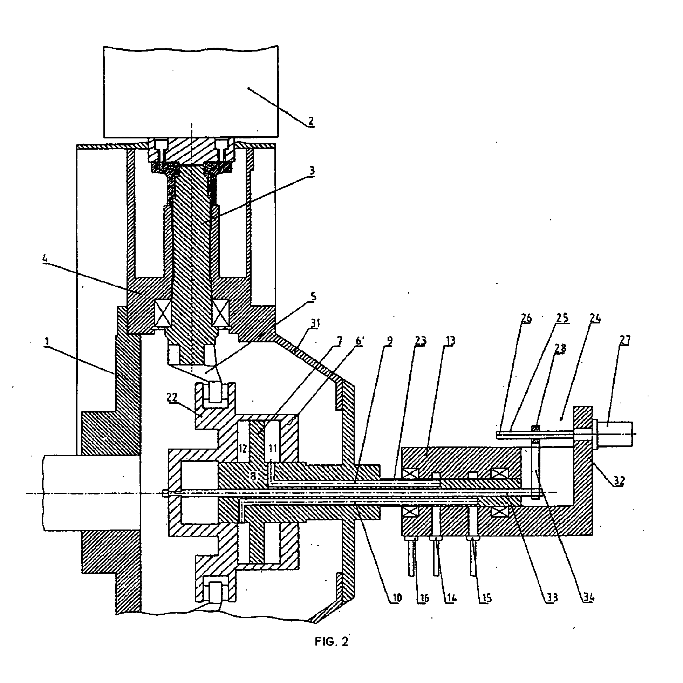

Die in Fig. 2 dargestellte Ausführungsform einer Verstelleinrichtung für einen Axialventilator entspricht in der Funktionsweise der in Fig. 1 dargestellten Verstelleinrichtung. Im Unterschied zu Fig. 1 ist jedoch der Verstellzylinder 6' der Verstelleinrichtung gemäß Fig. 2 axial verschiebbar, und die Kolbenstange 8' ist axial nicht verschiebbar angeordnet.

Der Verstellzylinder 6' ist fest mit der axial verschiebbaren Verstellscheibe 22 verbunden. Die Kolbenstange 8' mit dem darauf befestigten Kolben 7 ist mittels eines Stützkonus 31 mit dem Laufrad 1 verbunden. Das dem Laufrad 1 abgewandte Ende der Kolbenstange 8' läuft als Welle 23 innerhalb des nicht rotierenden Ölübergangsstück 13 um.

Der Sensorkopf 27 zusammen mit dem stabförmigen Sensorgehäuse 25 der magnetostriktiven Wegmesseinrichtung 24 ist bei der in Fig. 2 dargestellten Verstelleinrichtung fest in einem Halteflansch 32 eingesetzt. Der Halteflansch 32 ist an dem Ölübergangsstück 13 befestigt, das hier axial nicht verschiebbar ist. Dabei ist das Sensorgehäuse 25 in Richtung der Achse des Axialventilators und damit in Bewegungsrichtung des Verstellzylinders 6' ausgerichtet. Anstelle einer Wegmesseinrichtung 24 - wie dargestellt - können auch mehrere Wegmesseinrichtungen in den Halteflansch 32 des Ölübergangsstückes 13 eingesetzt werden.

Der Magnet 28 der magnetostriktiven Wegmesseinrichtung 24 ist als Ringmagnet ausgebildet, der das Sensorgehäuse umgibt. Jede montierte oder eingesetzte magnetostriktive Wegmesseinrichtung 24 hat ihren eigenen Magneten 28.

Der Verstellzylinder 6' ist fest mit einer Rückführstange 33 verbunden und führt die gleiche axiale Bewegung wie der Verstellzylinder aus. Die Rückführstange 33 ist fest mit einer Halterung 34 verbunden, an welcher wiederum der Magnet 28 bzw. die Magneten 28 der evtl. mehreren Wegmesseinrichtungen befestigt sind.

Um die Flügel 2 des Axialventilators zu verstellen, wird der Verstellzylinder 6' und damit auch die Verstellscheibe 22 und die Rückführstange 33 axial bewegt. Hierbei wird auch der Magnet 28 axial in seiner Position bewegt. Die aus Sensorgehäuse 25 und Sensorkopf 27 bestehende Wegmesseinrichtung 24 und der Halteflansch 32 auf dem Ölübergangsstück 13 bewegen sich axial nicht. Die Wegmesseinrichtung 24 gibt somit den Verstellhub als Wegsignal aus.

## Patentansprüche

1. Vorrichtung zur Messung des Verstellhubes einer hydraulischen Verstelleinrichtung (6, 6', 7, 8, 8' 9, 10, 11, 12) für Flügel (2) eines Laufrades (1) eines Axialventilators, in kombination mit der hydraulischen Verstelleinrichtung, wobei die hydraulische Verstelleinrichtung aus einem Verstellzylinder (6, 6') und einer Kolbenstange (8, 8') mit Kolben (7) besteht, von denen ein Teil axial verschiebbar und ein Teil nicht axial verschiebbar ist, wobei der axial verschiebbare Teil mit einer Verstellscheibe (22) verbunden ist, an der über verdrehbare Verstellhebel (5) jeweils Holme (3) der Flügel (2) befestigt sind und wobei eine aus dem Verstellzylinder (6, 6') herausragende Verlängerung der Kolbenstange (8, 8') von einem einer Ölversorgung (14, 15) des Verstellzylinders (6, 6') dienenden Ölübergangsstück (13) umschlossen ist, **dadurch gekennzeichnet, dass** die Vorrichtung als eine aus Sensorgehäuse (25) mit Wellenleiter (26), Sensorkopf (27) und ringförmigem Magnet (28) bestehende magnetostriktive Wegmesseinrichtung (24) ausgebildet und mit der hydraulischen Verstelleinrichtung (24) gekoppelt ist, dass das Sensorgehäuse (25) und der Sensorkopf (27) der magnetostriktiven Wegmesseinrichtung (24) mit dem Ölübergangsstück (13) verbunden sind und dass der Magnet (28) an den relativ zum Ölübergangsstück (13) axial verschiebbaren Teil der hydraulischen Verstelleinrichtung angeschlossen ist.

2. Vorrichtung nach Anspruch 1, **dadurch gekennzeichnet, dass** die magnetostriktive Wegmesseinrichtung (24) von einem Schutzrohr (30) umgeben ist, dass der Magnet (28) der magnetostriktiven Wegmesseinrichtung (24) an dem Schutzrohr (30) befestigt ist, das mit dem axial nicht verschiebbaren Verstellzylinder (6) verbunden ist.

3. Vorrichtung nach Anspruch 2, **dadurch gekennzeichnet, dass** das die Verlängerung der axial verschiebbaren Kolbenstange (8) umschließende Ölübergangsstück (13) mit einem Ringflansch (29) versehen ist und dass in dem Ringflansch (29) das Sensorgehäuse (25) und der Sensorkopf (27) einer oder mehrerer magnetostriktiver Wegmesseinrichtungen (24) befestigt sind.

4. Vorrichtung nach Anspruch 1, **dadurch gekennzeichnet, dass** durch die Kolbenstange (8') eine Rückführstange (33) hindurchgeführt ist, dass das eine Ende der Rückführstange (31) mit der Verstellscheibe (22) verbunden ist und dass an dem anderen Ende der Rückführstange (31) über eine Halterung (34) der Magnet (28) befestigt ist.

5. Vorrichtung nach Anspruch 4, **dadurch gekennzeichnet, dass** das Ölübergangsstück (13) mit einem Halteflansch (29) versehen ist und dass in dem Halteflansch (29) das Sensorgehäuse (25) und der Sensorkopf (27) einer oder mehrerer magnetostriktiver Wegmesseinrichtungen (24) befestigt sind.

## Claims

1. Device for measuring the displacement stroke of a hydraulic displacement device (6, 6', 7, 8, 8', 9, 10, 11, 12) for blades (2) in an impeller (1) of an axial ventilator in combination with the hydraulic displacement device, with the hydraulic displacement device consisting of a displacement cylinder (6, 6') and a connecting rod (8, 8') with pistons (7), one part of which can be displaced axially and one part of which cannot be displaced axially, with the axially displaceable part being connected to a displacement disk (22), to which pillars (3) of the blades (2) are fastened by way of rotatable displacement levers (5) and with an extension of the connecting rod (8, 8') protruding from the displacement cylinder (6, 6') being surrounded by an oil manifold (13) serving to supply oil (14, 15) to the displacement cylinder (6, 6'), **characterized in that** the device is embodied as a magnetostrictive displacement measuring device (24) consisting of a sensor housing (25) with waveguides (26), a sensor head (27) and annular magnet (28) and being coupled to the hydraulic displacement device (24), that the sensor housing (25) and the sensor head (27) of the magnetostrictive displacement measuring device (24) is connected to the oil manifold (13) and that the magnet (28) is connected to the part of the hydraulic displacement device which can be displaced axially relative to the oil manifold (13).

2. Device according to claim 1, **characterized in that** the magnetostrictive displacement measuring device (24) is surrounded by a protective tube (30), that the magnet (28) of the magnetostrictive displacement measuring device (24) is fastened to the protective tube (30), which is connected to the axially non-displaceable displacement cylinder (6).

3. Device according to claim 2, **characterized in that** the oil manifold (13) surrounding the extension of the axially displaceable connecting rod (8) is provided with an annular flange (29) and that the sensor housing (25) and the sensor head (27) of one or more magnetostrictive displacement measuring devices (24) are fastened in the annular flange (29) .

4. Device according to claim 1, **characterized in that** a returning rod (33) is passed through the connecting rod (8'), that the one end of the returning rod (31) is connected to the displacement disk (22) and that the magnet (28) is fastened to the other end of the returning rod (22) by way of a bracket (34) .

5. Device according to claim 4, **characterized in that** the oil manifold (13) is provided with a retaining flange (29) and that the sensor housing (25) and the sensor head (27) of one or more magnetostrictive displacement measuring devices (24) are fastened in the retaining flange (29).

## Revendications

1. Dispositif destiné à la mesure de la course de réglage d'une installation de réglage (6, 6', 7, 8, 8', 9, 10, 11, 12) hydraulique pour des ailettes (2) d'un rotor (1) d'un ventilateur axial en combinaison avec l'installation de réglage hydraulique, l'installation de réglage hydraulique étant constituée d'un cylindre de réglage (6, 6') et d'une tige de piston (8, 8') avec des pistons (7), dont une partie est coulissante axialement et une partie non coulissante axialement, la partie coulissante axialement étant reliée à un disque de réglage (22) sur lequel à chaque fois des montants (3) des ailettes (2) sont fixés au moyen de leviers de réglage (5) rotatifs et un prolongement, dépassant du cylindre de réglage (6, 6'), de la tige de piston (8, 8') étant entouré par une pièce de transfert d'huile (13) servant à une alimentation en huile (14, 15) du cylindre de réglage (6, 6'), **caractérisé en ce que** le dispositif est conçu comme une installation de mesure de déplacement (24) magnétostrictive, comprenant un boîtier de capteur (25) avec guide d'ondes (26), tête de capteur (27) et aimant (28) de forme annulaire, et est couplé avec l'installation de réglage (24) hydraulique, **en ce que** le boîtier de capteur (25) et la tête de capteur (27) de l'installation de mesure de déplacement (24) magnétostrictive sont reliés à la pièce de transfert d'huile (13) et **en ce que** l'aimant (28) est raccordé à la partie, coulissant axialement par rapport à la pièce de transfert d'huile (13), de l'installation de réglage hydraulique.

2. Dispositif selon la revendication 1, **caractérisé en ce que** l'installation de mesure de déplacement (24) magnétostrictive est entourée d'un tuyau de protection (30), **en ce que** l'aimant (28) de l'installation de mesure de déplacement (24) magnétostritive est fixé sur le tuyau de protection (30), qui est relié au cylindre de réglage (6) non coulissant axialement.

3. Dispositif selon la revendication 2, **caractérisé en ce que** la pièce de transfert d'huile (13) entourant le prolongement de la tige de piston (8) coulissant axialement est dotée d'une bride annulaire (29) et **en ce que** le boîtier de capteur (25) et la tête de capteur (27) d'une ou de plusieurs installations de mesure de déplacement (24) magnétostrictives sont fixés dans la bride annulaire (29).

4. Dispositif selon la revendication 1, **caractérisé en ce qu'**une tige de guidage de retour (33) est menée à travers la tige de piston (8'), **en ce que** l'une des extrémités de la tige de guidage de retour (33) est reliée au disque de réglage (22) et **en ce que** l'aimant (28) est fixé sur l'autre extrémité de la tige de guidage de retour (33) au moyen d'une fixation (34).

5. Dispositif selon la revendication 4, **caractérisé en ce que** la pièce de transfert d'huile (13) est dotée d'une bride de retenue (29) et **en ce que** le boîtier de capteur (25) et la tête de capteur (27) d'une ou de plusieurs installations de mesure de déplacement (24) magnétostrictives sont fixés dans la bride de retenue (29).
